# EUROPÄISCHE PATENTANMELDUNG

(11) **EP 3 118 999 A1**
(43) Veröffentlichungstag der Anmeldung: **18.01.2017**
(21) Anmeldenummer: 16179073.8
(22) Anmeldetag: 12.07.2016
(51) Int. Cl.: H03K 17/96

(54) **BEDIENEINRICHTUNG FÜR EIN ELEKTROGERÄT SOWIE ELEKTROGERÄT**

(30) Priorität: 17.07.2015 DE 102015213505
(71) Anmelder: E.G.O. Elektro-Gerätebau GmbH, 75038 Oberderdingen (DE)
(72) Erfinder: Kleinhans, Andreas, 75031 Eppingen (DE)
(74) Vertreter: Patentanwälte Ruff, Wilhelm, Beier, Dauster & Partner mbB

(57) **Zusammenfassung**

Eine Bedieneinrichtung für ein Kochfeld weist eine Kochfeldplatte als Bedienblende (36) und darunter einen Bauteilträger (30) mit Leiterbahnen und Kontaktfeldern auf. Auf dem Bauteilträger ist eine Sensorelementeinrichtung (11) mit einem Sensorelementgehäuse (13) angeordnet mit elektrisch leitfähigem Material zur Bildung eines kapazitiven Sensorelements an einer Oberseite. Zur elektrischen Kontaktierung des elektrisch leitfähigen Materials an den Bauteilträger ist in dem Sensorelementgehäuse eine Federelementaufnahme (28) vorgesehen, in die ein elektrisch leitfähiges Federelement (27) eingesetzt ist, das aus einem anderen Material besteht als das elektrisch leitfähige Material für das kapazitive Sensorelement. Das Federelement steht im in die Federelementaufnahme eingesetzten Zustand aus ihr heraus vor und stellt bei an dem Bauteilträger befestigter Sensorelementeinrichtung durch Zusammendrücken und somit drücken seiner Unterseite (27') auf eine Kontaktfeld (31) auf der Leiteplatte (30) die elektrische Kontaktierung her.

## Beschreibung

### Anwendungsgebiet und Stand der Technik

Die Erfindung betrifft eine Bedieneinrichtung für ein Elektrogerät, insbesondere für ein Elektrokochfeld, sowie ein Elektrogerät mit einer solchen Bedieneinrichtung.

Aus der EP 2809006 A1 ist eine Bedieneinrichtung für ein Kochfeld bekannt mit einer Sensorelementeinrichtung, bei der Sensorelementgehäuse auf einem Bauteilträger unter einer Bedienblende, die durch die Kochfeldplatte gebildet wird, angeordnet sind. Zur Bildung von kapazitiven Sensorelementen der Sensorelementeinrichtung sind an der Oberseite des Sensorelementgehäuses schmale längliche oder runde, zinnenartige Vorsprünge vorgesehen, die aus elektrisch leitfähigem elastischem Material bestehen. Sie liegen einerseits an der Unterseite der Kochfeldplatte an und bilden so kapazitive Sensorelemente für einen kapazitiven Berührungsschalter durch Betätigung mit einem auf die Oberseite der Kochfeldplatte darüber aufgelegten Finger. Eine elektrische Kontaktierung an den Bauteilträger erfolgt über an die Unterseite des Sensorelementgehäuses reichende Abschnitte des elektrisch leitfähigen elastischen Materials, die dort auf Kontaktfelder aufgedrückt sind. Hier kann es aber im Dauerbetrieb, insbesondere unter Erwärmung, zu Materialveränderungen und somit zu Schwierigkeiten bei der elektrischen Kontaktierung kommen, was im schlimmsten Fall zu Funktionsstörungen sowie zum Ausfall der Bedieneinrichtung führen kann.

### Aufgabe und Lösung

Der Erfindung liegt die Aufgabe zugrunde, eine eingangs genannte Bedieneinrichtung sowie ein eingangs genanntes Elektrogerät zu schaffen, mit denen Probleme des Stands der Technik gelöst werden können und es insbesondere möglich ist, eine Bedieneinrichtung sowie ein solches Elektrogerät praxistauglich und gut funktionierend herstellen zu können.

Gelöst wird diese Aufgabe durch eine Bedieneinrichtung mit den Merkmalen des Anspruchs 1 sowie ein Elektrogerät mit den Merkmalen des Anspruchs 15. Vorteilhafte sowie bevorzugte Ausgestaltungen der Erfindung sind Gegenstand der weiteren Ansprüche und werden im Folgenden näher erläutert. Dabei werden manche der Merkmale nur für die Bedieneinrichtung oder nur für das Elektrogerät beschrieben. Sie sollen unabhängig davon jedoch sowohl für die Bedieneinrichtung als auch für das Elektrogerät selbstständig gelten können. Der Wortlaut der Ansprüche wird durch ausdrückliche Bezugnahme zum Inhalt der Beschreibung gemacht.

Es ist vorgesehen, dass die Bedieneinrichtung eine Bedienblende aufweist, die vorteilhaft zumindest im Bereich der Bedieneinrichtung geschlossen sein kann. Diese Bedienblende kann auch Teil des sonstigen Elektrogeräts sein, insbesondere im Falle eines Kochfelds als Elektrogerät mit einer Kochfeldplatte als Bedienblende. Unter der Bedienblende ist ein Bauteilträger angeordnet, beispielsweise eine Leiterplatte. Der Bauteilträger weist Leiterbahnen und Kontaktfelder zur elektrischen Kontaktierung von an ihm angeordneten Bauteilen auf. Es ist also zumindest weitgehend ein im Wesentlichen üblicher Bauteilträger bzw. eine übliche Leiterplatte. Mindestens eines der auf dem Bauteilträger angeordneten Bauteile ist eine Sensorelementeinrichtung, die ein Sensorelementgehäuse aufweist, das im Wesentlichen blockartig ausgebildet sein kann, vorteilhaft flach und insbesondere im Wesentlichen quaderartig ausgebildet ist. Das Sensorelementgehäuse weist elektrisch leitfähiges Material auf, welches vorteilhaft elastisch ist, um ein kapazitives Sensorelement der Sensorelementeinrichtung zu bilden für einen Berührungsschalter. Das elektrisch leitfähige Material ist an einer Oberseite bzw. an einem oberen Bereich der Sensorelementeinrichtung bzw. des Sensorelementgehäuses angeordnet. Vorteilhaft liegt das elektrisch leitfähige Material dabei an der Unterseite der Bedienblende an. Das elektrisch leitfähige Material kann über die Oberseite der Sensorelementeinrichtung bzw. des Sensorelementgehäuses überstehen, muss dies aber nicht. In mindestens einem Bereich des Sensorelementgehäuses kann das elektrisch leitfähige Material nach unten an einen unteren Bereich der Sensorelementeinrichtung geführt sein. Dies ist aber nur optional, wesentlich ist das Vorhandensein an der Oberseite bzw. im oberen Bereich.

Erfindungsgemäß ist vorgesehen, dass zur elektrischen Kontaktierung des elektrisch leitfähigen Materials an den Bauteilträger bzw. eine auf dem Bauteilträger angeordnete oder mit dem Bauteilträger verbundene Steuerung in dem Sensorelementgehäuse und/oder in dem Bauteilträger selbst eine Federelementaufnahme vorgesehen ist, wobei in diese Federelementaufnahme ein elektrisch leitfähiges elastisches Federelement eingesetzt ist. Dieses ist vorteilhaft anders ausgebildet bzw. besteht aus einem anderen Material als das elektrisch leitfähige Material für das kapazitive Sensorelement. Dieses Federelement kann im in die Federelementaufnahme eingesetzten Zustand aus ihr herausstehen, zumindest bevor die Sensorelementeinrichtung auf dem Bauteilträger befestigt worden ist, vorteilhaft auch danach. Mit dem Federelement wird bei zusammengebauter Bedieneinrichtung, wenn also die Sensorelementeinrichtung an dem Bauteilträger befestigt ist bzw. aufgesetzt ist, unter Zusammendrücken des Federelements die elektrische Kontaktierung hergestellt.

Somit wird mit der Erfindung der Vorteil erreicht, dass für die elektrische Kontaktierung der Sensorelementeinrichtung bzw. des kapazitiven Sensorelements und damit des dieses bildenden elektrisch leitfähigen Materials an den Bauteilträger ein elektrisch leitendes elastisches Bauteil verwendet wird, nämlich das beschriebene Federelement, das aus anderem Material besteht als das für das kapazitive Sensorelement. Die Eigenschaften des Federelements können vor allem auf diese elastische bzw. federnde elektrische Kontaktierung abgestimmt sein und müssen somit nicht dieselben sein wie für die Bildung des kapazitiven Sensorelements. Insbesondere kann es ein elektrisch leitfähiges elastisches Material sein, welches bei höheren Temperaturen, wie sie beispielsweise unterhalb von Kochfeldern im Betrieb auftreten können, also bis zu 150°C oder sogar bis zu 180°C, seine elastischen Eigenschaften beibehält. Dadurch wird eine permanente sichere elektrische Kontaktierung gewährleistet, auch unter Temperatureinwirkung, welche das elektrisch leitfähige Material für das kapazitive Sensorelement negativ beeinträchtigen würde.

Das elektrisch leitfähige Material für das kapazitive Sensorelement ist vorteilhaft ein thermoplastischer Elastomer (auch TPE), besonders vorteilhaft auf Silikonbasis. Es kann an das Sensorelementgehäuse in einem Mehrkomponenten-Spritzgussverfahren angespritzt oder eingespritzt sein.

Eine Federelementaufnahme kann allgemein als länglicher Kanal ausgebildet sein, die Längsrichtung ist besonders vorteilhaft in etwa rechtwinklig zur Fläche des Bauteilträgers. So wird zumindest bei Federelementen in Form eines Körpers aus elastischem Material, beispielsweise aus elektrisch leitfähigem Kunststoff, eine optimale Federwirkung erreicht. Durch die genannte Ausrichtung des länglichen Kanals kann die Federwirkung des Federelements optimal ausgenutzt werden.

Bevorzugt ist eine Federelementaufnahme für ein Federelement in Form eines elastischen Körpers zylindrisch, insbesondere rundzylindrisch. Kleine Vorsprünge, Widerhaken oder Querschnittsverengungen können vorgesehen sein, um ein eingesetztes Federelement darin zu halten.

In einer ersten grundsätzlichen Ausgestaltung der Erfindung ist die Federelementaufnahme im Sensorelementgehäuse vorgesehen, vorteilhaft an dessen Unterseite bzw. unten daran. Sie kann durch das Sensorelementgehäuse durchgehen, muss dies aber nicht, sie muss eben nur an der Unterseite offen sein bzw. hier kann das Federelement herausstehen.

Das elektrisch leitfähige Material des Sensorelementgehäuses kann bis an die Federelementaufnahme reichen, beispielsweise als obere Begrenzung, bzw. sogar in sie hineinragen. Eine elektrische Kontaktierung an das Federelement kann somit durch einen anliegenden Kontakt hergestellt werden. Dieser Kontakt sollte sozusagen derart unter anliegendem Druck erfolgen, dass er auch bei Bewegungen eines der Materialien oder kleineren Formveränderungen nicht unterbrochen wird. Deswegen wird es als besonders vorteilhaft angesehen, wenn das elektrisch leitfähige Material in die Federelementaufnahme hineinragt oder alternativ einen oberen Anschlag bildet bzw. im oberen Bereich der Federelementaufnahme verläuft, beispielsweise auch an der Seite. So ist eine automatische Anlage und damit elektrische Kontaktierung zwischen elektrisch leitfähigem Material und Federelement gewährleistet, wenn das Federelement in der Federelementaufnahme eingesetzt ist und insbesondere bei zusammengebauter Bedieneinrichtung in diese hineingedrückt wird bzw. in dieser nach oben drückt.

In weiterer Ausgestaltung der Erfindung ist es von Vorteil, wenn das Federelement aus dem Sensorelementgehäuse heraussteht und dabei ein auf die Oberseite des Bauteilträgers aufgebrachtes Kontaktfeld elektrisch kontaktiert. So kann das Federelement sozusagen auf das Kontaktfeld gedrückt werden, wie dies an sich aus dem Stand der Technik bekannt ist. Von dem Kontaktfeld kann dann eine Leiterbahn an eine Steuerung bzw. Auswertung abgehen. Zusätzlich ist es möglich, ein die elektrische Verbindung verbesserndes Mittel wie Leitpaste oder Leitkleber vorzusehen, notwendig ist dies aber nicht. Weitere Mittel können eine Erhebung oder ein Vorsprung an dem Kontaktfeld sein, beispielsweise nach Art eines nach oben stehenden Nagels oder Stifts bzw. Pins. Dies ist dann aber bei der Montage schwieriger zu handhaben.

In einer zweiten grundsätzlichen Ausgestaltung der Erfindung ist die Federelementaufnahme am bzw. im Bauteilträger vorgesehen. Hier ist es einerseits möglich, sie auch als eine Art Bohrung oder Vertiefung im Bauteilträger auszubilden, in die ein zuvor entsprechend beschriebenes Federelement eingesetzt wird und vorteilhaft unverlierbar darin gehalten ist. Eine elektrische Kontaktierung an eine solche Bohrung kann beispielsweise über eine elektrisch leitfähige Innenwandung der Bohrung erfolgen, welche dann mit einer vorgenannten Leiterbahn auf dem Bauteilträger elektrisch verbunden ist. Dies kann mit bestehender Technik mit einer Verkupferung gemacht werden. In diesem Fall kann das elektrisch leitfähige Material am Sensorelementgehäuse bis an dessen Unterseite oder bis an einen von unten durch das nach oben stehende Federelement erreichbaren Bereich verlaufen, um dann im fertig montierten Zustand durch Anlegen einen elektrischen Kontakt herzustellen. Auch hier kann ein solches Federelement also ein länglicher, beispielsweise zylindrischer bzw. rundzylindrischer, Körper aus elastischem und elektrisch leitfähigem Material sein, beispielsweise in geschäumter Form.

In vorteilhafter Ausgestaltung der Erfindung ist pro kapazitivem Sensorelement mindestens ein Federelement als elektrische Kontaktierung vorgesehen. Besonders vorteilhaft ist genau ein Federelement pro kapazitivem Sensorelement vorgesehen, also pro zusammenhängendem Gebilde aus elektrisch leitfähigem Material am Sensorelementgehäuse. Eine einzige elektrische Kontaktierung pro Sensorelement wird als ausreichend angesehen. Dazu ist das Federelement mit dem kapazitiven Sensorelement bzw. mit dessen elektrisch leitfähigem Material elektrisch leitend verbunden.

Das elektrisch leitfähige Material verläuft in Ausgestaltung der Erfindung an dem Sensorelementgehäuse zumindest teilweise in Vertiefungen, beispielsweise wenige mm tief, insbesondere ist es darin eingespritzt. Diese Vertiefungen sollten zumindest auf einer Oberseite des Sensorelementgehäuses sein, um hier das kapazitive Sensorelement zu bilden. Auch eine Verbindung von zusammenhängenden Bereichen verläuft vorteilhaft zumindest teilweise im Sensorelementgehäuse, wodurch auch eine bessere Befestigung möglich ist. Insbesondere eine elektrische Kontaktierung an das federnde Element als Kontaktelement, also an die Federelementaufnahme hin, kann in dem Sensorelementgehäuse verlaufen.

In vorteilhafter Ausgestaltung der Erfindung wird das gesamte elektrisch leitfähige Material, bevorzugt das vorgenannte TPE, in einem Schritt an das Sensorelementgehäuse angespritzt. In einem weiteren Schritt ist es möglich, auch das Federelement aus entsprechendem anderem Material anzuspritzen. Für die gewünschten elastischen bzw. federnden Eigenschaften wird es aber als bevorzugt angesehen, dieses separat herzustellen, insbesondere auch um es für die gewünschte Elastizität aufschäumen zu können, und dann einzusetzen.

In weiterer Ausgestaltung der Erfindung ist es möglich, in dem Sensorelementgehäuse lichtdurchlässige Bereiche vorzusehen. Diese können zumindest teilweise nahe zu dem elektrisch leitfähigen Material vorgesehen sein oder innerhalb von Bereichen, um die das elektrisch leitfähige Material herum verläuft. Diese lichtdurchlässigen Bereiche können auf an sich bekannte Art und Weise mit Lichtleitermaterial gefüllt sein und dabei von unten nach oben durch das Sensorelementgehäuse hindurchgehen.

Auf dem Bauteilträger können noch weitere Bauteile, insbesondere eine komplette Steuerung, des Kochfelds angeordnet sein. Vorteilhaft weist eine Sensorelementeinrichtung genau ein einziges kapazitives Sensorelement auf und besonders vorteilhaft auch nur eine einzige elektrische Kontaktierung an einen genannten Bauteilträger. Auf dem Bauteilträger der Bedieneinrichtung können mehrere solcher Sensorelementeinrichtungen angeordnet sein, die unter Umständen auch jeweils unterschiedlich ausgebildet sind. Zumindest zwei dieser Sensorelementeinrichtungen sind dann wie zuvor beschrieben ausgebildet mit dem elektrisch leitfähigen Federelement zur elektrischen Kontaktierung.

Alternativ zu einem elektrisch leitfähigen Federelement zur elektrischen Kontaktierung in Form eines Kunststoffkörpers kann eine Metallfeder verwendet werden, beispielsweise eine Schraubenfeder oder eine Blattfeder. Speziell eine Schraubenfeder aus metallischem Material kann aufgrund ihrer im Wesentlichen rundzylindrischen länglichen äußeren Form ähnlich verwendet werden wie ein zuvor beschriebenes elektrisch leitfähiges Federelement als elektrischer Kontakt. Auch eine solche metallische Schraubenfeder kann in eine längliche, kanalartige Federelementaufnahme eingesetzt werden und sowohl an das elektrisch leitfähige Material für das kapazitive Sensorelement als auch an ein Kontaktfeld auf dem Bauteilträger angedrückt sein zur jeweiligen elektrischen Kontaktierung.

Eine erfindungsgemäße Bedieneinrichtung kann in ein erfindungsgemäßes Elektrogerät eingebaut sein und dabei von unten an eine Bedienblende angedrückt sein, insbesondere federnd angedrückt sein, wobei die Bedienblende Teil einer Außenwand oder Seitenwand des Elektrogeräts ist. Hierzu kann der Bauteilträger federnd gelagert auf eine Unterlage oder in einem Gehäuse sitzen, wobei dieses Gehäuse direkt oder indirekt mit der Bedienblende zu einer Baueinheit bzw. als Elektrogerät verbunden sein kann. Vorteilhaft ist es ein Kochfeld und die Bedieneinrichtung ein Teil davon, wobei die Bedienblende von einer Kochfeldplatte gebildet sein kann.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig.1: eine Schrägansicht einer erfindungsgemäßen Sensorelementeinrichtung einer erfindungsgemäßen Bedieneinrichtung,
- Fig. 2: eine Seitenansicht der Sensorelementeinrichtung aus Fig. 1 zwischen einer Kochfeldplatte und einer Leiterplatte,
- Fig. 3: einen Ausschnitt aus einem erfindungsgemäßen Kochfeld entsprechend dem zusammengesetztem Zustand der Bauteile aus Fig. 2,
- Fig. 4: eine schräge Unteransicht der Sensorelementeinrichtung aus Fig. 1,
- Fig. 5: eine Unteransicht der Sensorelementeinrichtung aus Fig. 1,
- Fig. 6: eine Schnittdarstellung A-A durch die Sensorelementeinrichtung aus Fig. 4 in Schrägdarstellung,
- Fig. 7: eine ähnliche Schnittdarstellung B-B wie in Fig. 6 mit leicht nach hinten versetzter Schnittebene und
- Fig. 8: eine Schnittdarstellung durch eine alternative Ausgestaltung einer elektrischen Kontaktierung mit in einer Leiterplatte gehaltertem Federelement.

### Detaillierte Beschreibung der Ausführungsbeispiele

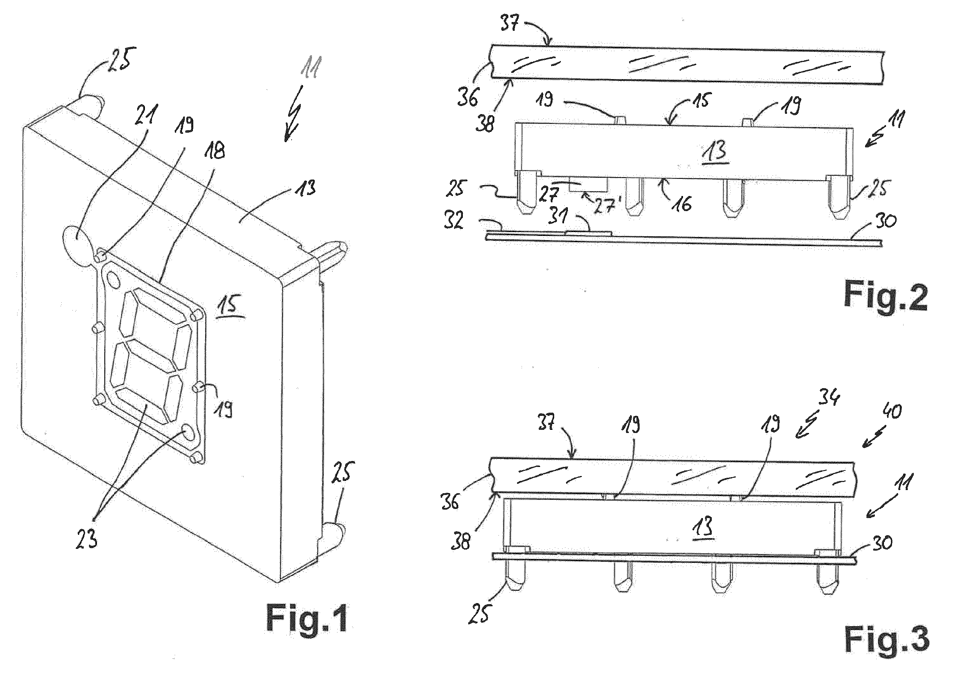

In der Fig. 1 ist in schräger Ansicht eine Sensorelementeinrichtung 11 gemäß der Erfindung dargestellt mit einem blockartigen bzw. quaderartigen und im Wesentlichen flachen Sensorelementgehäuse 13. Es kann aus Kunststoff bestehen und im Kunststoffspritzgussverfahren hergestellt sein, vorteilhaft mit mehreren anderen Bestandteilen zusammen. Das Sensorelementgehäuse 13 weist eine hier sichtbare Oberseite 15 auf und eine aus den nachfolgenden Figuren ersichtliche Unterseite 16. Als eingangs genanntes elektrisch leitfähiges Material ist vorbeschriebenes elastisches thermoplastisches Elastomer bzw. TPE daran vorgesehen, insbesondere in entsprechenden Bahnen oder Kanälen als TPE-Material 18. Hier bildet es eine Art umlaufenden rechteckigen Rahmen. Auf diesen Rahmen aufgesetzt bzw. integral angeformt sind TPE-Vorsprünge 19, die gemäß der eingangs genannten EP 2809006 A1 zum Anliegen an einer Unterseite einer Bedienblende vorgesehen sind. Links oben geht das TPE-Material 18 in einen TPE-Kontakt 21 über, der nachfolgend noch im Detail erläutert wird.

Innerhalb des von dem TPE-Material 18 gebildeten Rahmens befindet sich eine sogenannte Sieben-Segment-Anzeige, die aus mehreren Lichtleitern 23 gebildet ist. Sie bestehen aus lichtverteilendem bzw. Diffusormaterial und können in das Sensorelementgehäuse 13 eingesetzt oder eingespritzt sein.

In der Seitenansicht der Fig. 2 ist die Sensorelementeinrichtung 11 mit dem Sensorelementgehäuse 13 dargestellt samt Oberseite 15 und Unterseite 16. Hier ist noch einmal zu ersehen, wie die TPE-Vorsprünge 19 nach oben über die Oberseite 15 überstehen. An der Unterseite 16 sind mehrere Haltefüße 25 angeformt. Ebenso steht ein rundzylindrisches Federelement 27 nach unten über, das nachfolgend noch näher erläutert wird.

Unterhalb des Sensorelementgehäuses 13 ist eine Leiterplatte 30 als eingangs genannter Bauteilträger dargestellt. Beispielhaft ist auf der Oberseite der Leiterplatte 30 auf an sich übliche Art und Weise ein Kontaktfeld 31 vorgesehen mit einer davon abgehenden Leiterbahn 32. Das Kontaktfeld 31 ist vorteilhaft rund oder gitterartig. Weitere Kontaktfelder und Leiterbahnen sowie vor allem Bauteile wie beispielsweise eine eingangs genannte Steuerung sind vorteilhaft auf der Leiterplatte 30 vorhanden, hier aber nicht dargestellt.

Mit etwas Abstand ist über dem Sensorelementgehäuse 13 eine Kochfeldplatte 36 dargestellt. Mit ihrer Unterseite 38 liegt sie auf dem Sensorelementgehäuse 13 auf.

In der Fig. 3 ist in Seitenansicht dargestellt, wie nach dem Aufsetzen des Sensorelementgehäuses 13 auf die Leiterplatte 30 auch die Kochfeldplatte 36 aufgesetzt ist, die hier eine eingangs genannte Bedienblende bildet und somit auch integraler Bestandteil einer erfindungsgemäßen Bedieneinrichtung 40 ist. Somit zeigt die Fig. 3 auch einen Ausschnitt eines erfindungsgemäßen Kochfelds 34, bei dem an anderer Stelle unter der Kochfeldplatte 36 noch entsprechende Heizeinrichtungen angeordnet sind. Durch das Andrücken des Sensorelementgehäuses 13 an die Unterseite 38 der Kochfeldplatte 36 als Bedienblende liegen die TPE-Vorsprünge 13 nicht nur daran an, sondern werden dagegen gepresst und auch etwas aufgeweitet bzw. flachgedrückt. In ähnlicher Form liegt direkt an der Unterseite 16 des Sensorelementgehäuses 13 die Leiterplatte 30 an, wobei das Federelement 27 auf das Kontaktfeld 31 gedrückt wird und fest daran anliegt sowie einen sicheren elektrischen Kontakt herstellt.

Die TPE-Vorsprünge 19, möglicherweise zusammen mit dem TPE-Material 18 an der Oberseite 15 des Sensorelementgehäuses 13, bilden durch ihre Anlage an der Unterseite 38 der Kochfeldplatte 36 auf bekannte Art und Weise ein kapazitives Sensorelement. Durch Auflegen eines Fingers auf eine Oberseite 37 der Kochfeldplatte 36 oberhalb der TPE-Vorsprünge 19 bzw. oberhalb des Sensorelementgehäuses 13 kann auf bekannte Art und Weise durch dieses kapazitive Sensorelement ein Bedienvorgang erkannt und somit ein Schaltvorgang ausgelöst werden. Die elektrische Kontaktierung an dieses kapazitive Sensorelement erfolgt dann eben über den TPE-Kontakt 21 an das elektrisch leitfähige Federelement 27, das Kontaktfeld 31 sowie die Leiterbahn 32.

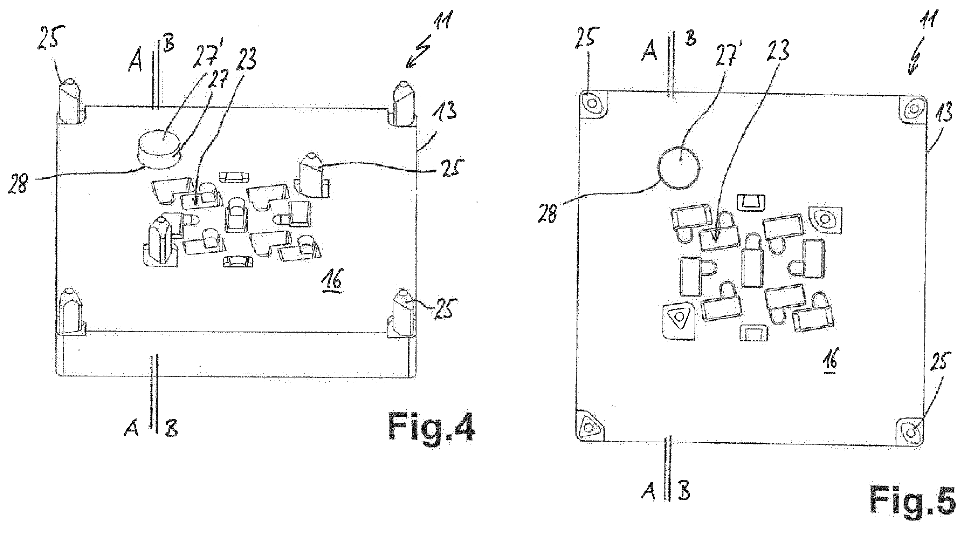

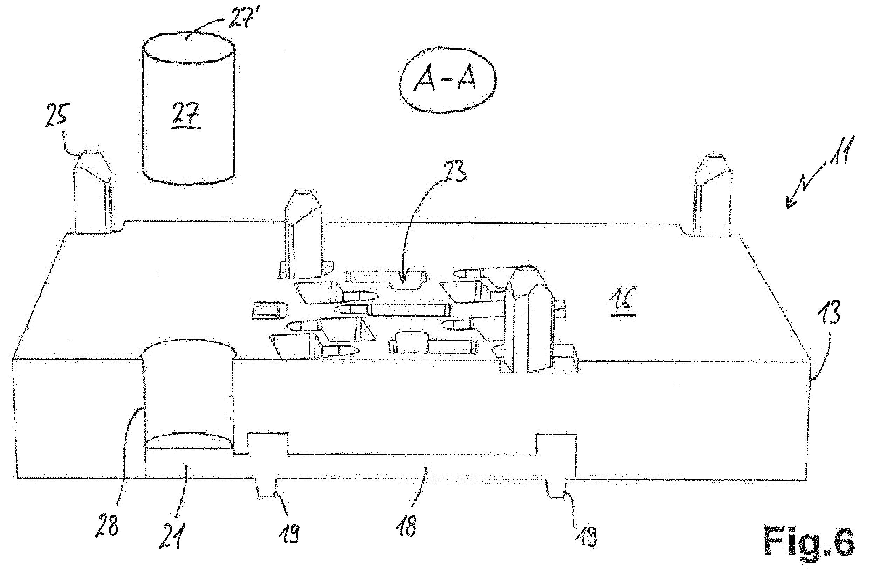

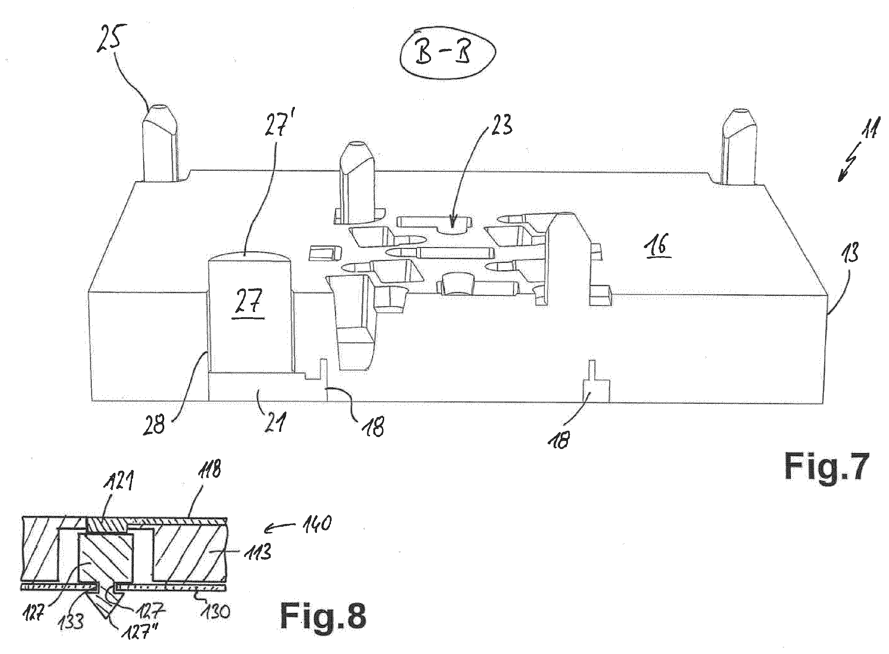

In der Schrägansicht der Fig. 4 auf die Unterseite 16 der Sensorelementeinrichtung 11 bzw. des Sensorelementgehäuses 13 sowie der Unteransicht der Fig. 5 sind die Lichtleiter 23 zu erkennen, die hier noch größere Freiräume über sich aufweisen, die dann über SMD-LED auf der Leiterplatte 30 reichen. Vor allem steht an der Unterseite 16 das Federelement 27 hervor, wobei es beispielsweise 1 mm bis 3mm oder sogar 5mm über die Unterseite 16 des Sensorelementgehäuses 13 überstehen kann. Eingezeichnet sind auch die Schnittlinien für die in den Fig. 6 und 7 dargestellten Schnitte A-A und B-B.

In der schrägen Schnittdarstellung A-A der Fig. 6 durch das Sensorelementgehäuse 13 ist zu sehen, wie in einer Vertiefung das TPE-Material 18 eingespritzt ist. Im Bereich der Sieben-Segment-Anzeige verläuft es durchgehend, beispielsweise 1 mm bis 3mm tief im Sensorelementgehäuse 13. Die TPE-Vorsprünge 19 stehen etwa 1 mm bis 2mm über.

Links neben den TPE-Vorsprüngen 19 ist der TPE-Kontakt 21 dargestellt, der aus einer Art Platte besteht, die in eine rundzylindrische und längliche Federelementaufnahme 28 eingespritzt ist. Die durchgehende elektrische Verbindung vom TPE-Kontakt 21 zum TPE-Material 18 bzw. den TPE-Vorsprüngen 19 ist gut zu erkennen.

In die Federelementaufnahme 28 wird ein darüber dargestelltes rundzylindrisches Federelement 27 eingesetzt. Die hier nicht dargestellte zum TPE-Kontakt 21 hin weisende Seite des Federelements 27 liegt an diesem an und stellt die elektrische Verbindung her. Die Unterseite 27' liegt entsprechend der Fig. 2 an dem Kontaktfeld 31 auf der Leiterplatte 30 an.

Das Federelement 27 ist aus elektrisch leitfähigem Material hergestellt, das elastisch ist, unter Umständen sowohl elastisch ist durch seine inhärente Materialeigenschaft als auch durch seine Ausbildung, welche vorteilhaft ein geschäumtes Material ist. Das Material kann beispielsweise auf Silikonbasis oder Kautschukbasis beruhen, als elektrisch leitfähiger Zusatz kann Graphit-oder Metallpulver beigefügt sein. Derartige elektrisch leitfähige Federelemente 27 sind grundsätzlich aus dem Stand der Technik bekannt, siehe beispielsweise die EP 859467 A.

In der weiteren Schnittdarstellung der Fig. 7 gemäß dem Schnitt B-B etwa 1 mm hinter der Schnittdarstellung A-A der Fig. 6 ist das Federelement 27 in die Federelementaufnahme 28 eingesetzt. Ansonsten ist hier auch noch zu sehen, dass durch die etwas versetzte Schnittebene das TPE-Material 18 nur teilweise zu sehen ist, insbesondere der längliche Abschnitt zwischen den beiden TPE-Vorsprüngen 19 der Fig. 6 ist hier in diesem Schnitt nicht mehr enthalten.

Aus der Fig. 7 ist auch zu ersehen, dass bei Anlage der Unterseite 16 des Sensorelementgehäuses 13 auf der Oberseite der Leiterplatte 30 das Federelement 27 um ein gutes Stück zusammengedrückt wird, beispielsweise etwa 20% bis 25%. Das Material des Federelements 27 ist allgemein so gewählt, dass es durch Temperatureinwirkung sowie Alterung seine Elastizität nicht verliert und damit stets der elektrische Kontakt gewährleistet ist.

In der Fig. 8 ist ein Ausschnitt einer alternativen Bedieneinrichtung 140 dargestellt, bei der ein Federelement 127 nicht in einem Sensorelementgehäuse 113 ähnlich demjenigen aus den Fig. 1 bis 7 gehalten ist, sondern an einer Leiterplatte 130. Ein Loch 133 in der Leiterplatte 130 bildet dabei die erfindungsgemäße Federelementaufnahme, wobei dieses Loch 133 auf übliche Art und Weise innen verkupfert sein kann und mit einer auf der Oberseite um dieses Loch 133 herum versehenen Kontaktfeldfläche verbunden ist. Von dieser geht eine nicht dargestellte Leiterbahn ab. Das Federelement 127 weist eine Verjüngung 127' und daran anschließend eine verbreiterte Spitze 127" auf, so dass es von oben in das Loch 133 in der Leiterplatte 130 eingesteckt wird. Der elektrische Kontakt erfolgt durch Anliegen an der Innenwandung des Lochs 133 mit der Verjüngung 127' sowie an einer Kontaktfeldfläche auf der Oberseite der Leiterplatte 130. Durch die verbreiterte Spitze 127" ist das Federelement 127 fest an der Leiterplatte 130 gehalten.

Mit einer Oberseite liegt das Federelement 127 an einem TPE-Kontakt 121 im Sensorelementgehäuse 113 an und stellt so die elektrische Kontaktierung her. Von dem TPE-Kontakt 121 geht TPE-Material 118 ab hin zu einem von dem TPE-Material gebildeten Sensorelement, beispielsweise entsprechend der zuvor beschriebenen Figuren.

Anhand der Fig. 8 ist auch leicht vorstellbar, wie anstelle eines Federelements aus einem Vollkörper aus elektrisch leitfähigem und elastischem Material beispielsweise eine metallische Schraubenfeder verwendet werden könnte. In ähnlicher Form könnte auch eine metallische Blattfeder odgl. vorgesehen sein, die beispielsweise in einem Loch 133 der Leiterplatte 130 festgelötet ist und über die dann ein Sensorelementgehäuse auf die Leiterplatte aufgesetzt wird.

Dabei würde dann die Schraubenfeder oder Blattfeder auch wieder an einem TPE-Kontakt anliegen bzw. diesen elektrisch kontaktieren.

## Patentansprüche

1. Bedieneinrichtung für ein Elektrogerät, insbesondere für ein Kochfeld, **gekennzeichnet durch**:
- eine Bedienblende,
- einen Bauteilträger, der unter der Bedienblende angeordnet ist,
- der Bauteilträger weist Leiterbahnen und Kontaktfelder zur elektrischen Kontaktierung von auf dem Bauteilträger angeordneten Bauteilen auf,
- mindestens eines der auf dem Bauteilträger angeordneten Bauteile ist eine Sensorelementeinrichtung mit einem Sensorelementgehäuse, die elektrisch leitfähiges Material an dem Sensorelementgehäuse aufweist zur Bildung eines kapazitiven Sensorelements, wobei das elektrisch leitfähige Material an einer Oberseite oder an einem oberen Bereich der Sensorelementeinrichtung angeordnet ist,
**dadurch** gekennzeichnet, dass
- zur elektrischen Kontaktierung des elektrisch leitfähigen Materials an den Bauteilträger in dem Sensorelementgehäuse und/oder in dem Bauteilträger eine Federelementaufnahme vorgesehen ist, in die ein elektrisch leitfähiges Federelement eingesetzt ist, das aus einem anderen Material besteht als das elektrisch leitfähige Material für das kapazitive Sensorelement,
- das Federelement im in die Federelementaufnahme eingesetzten Zustand aus ihr heraus vorsteht, um bei an dem Bauteilträger befestigter Sensorelementeinrichtung unter Zusammendrücken die elektrische Kontaktierung herzustellen.

2. Bedieneinrichtung nach Anspruch 1, **dadurch gekennzeichnet, dass** die Federelementaufnahme ein länglicher Kanal ist, insbesondere mit Längsrichtung rechtwinklig zur Fläche des Bauteilträgers, und/oder dass die Federelementaufnahme zylindrisch ist, insbesondere rundzylindrisch.

3. Bedieneinrichtung nach Anspruch 1 oder 2, **dadurch gekennzeichnet, dass** die Federelementaufnahme zylindrisch ist, insbesondere rundzylindrisch.

4. Bedieneinrichtung nach einem der vorhergehenden Ansprüche, **dadurch gekennzeichnet, dass** die Federelementaufnahme im Sensorelementgehäuse vorgesehen ist.

5. Bedieneinrichtung nach einem der vorhergehenden Ansprüche, **dadurch gekennzeichnet, dass** das elektrisch leitfähige Material am Sensorelementgehäuse bis an die Federelementaufnahme reicht oder bis in sie hineinragt.

6. Bedieneinrichtung nach Anspruch 5, **dadurch gekennzeichnet, dass** das elektrisch leitfähige Material am Sensorelementgehäuse einen oberen Anschlag der Federelementaufnahme bildet.

7. Bedieneinrichtung nach Anspruch 5 oder 6, **dadurch gekennzeichnet, dass** das elektrisch leitfähige Material am Sensorelementgehäuse im oberen Bereich der Federelementaufnahme an der Seite verläuft.

8. Bedieneinrichtung nach einem der vorhergehenden Ansprüche, **dadurch gekennzeichnet, dass** eine elektrische Kontaktierung des aus dem Sensorelementgehäuse herausstehenden Federelements an den Bauteilträger mittels eines auf die Oberseite des Bauteilträgers aufgebrachten Kontaktfelds erfolgt, an dem eine Leiterbahn angeschlossen ist.

9. Bedieneinrichtung nach Anspruch 1, **dadurch gekennzeichnet, dass** die Federelementaufnahme am Bauteilträger vorgesehen ist, insbesondere als Bohrung im Bauteilträger,

10. Bedieneinrichtung nach Anspruch 9, **dadurch gekennzeichnet, dass** die Innenwandung der Bohrung elektrisch leitfähig ist und elektrisch leitend mit einer Leiterbahn auf dem Bauteilträger verbunden ist.

11. Bedieneinrichtung nach einem der vorhergehenden Ansprüche, **dadurch gekennzeichnet, dass** pro kapazitivem Sensorelement mindestens ein Federelement vorgesehen ist, vorzugsweise genau ein Federelement, und elektrisch leitend mit diesem verbunden ist.

12. Bedieneinrichtung nach einem der vorhergehenden Ansprüche, **dadurch gekennzeichnet, dass** das Federelement aus elektrisch leitfähigem und geschäumtem flexiblem bzw. elastischem Kunststoff besteht.

13. Bedieneinrichtung nach einem der vorhergehenden Ansprüche, **dadurch gekennzeichnet, dass** das elektrisch leitfähige Material an dem Sensorelementgehäuse zumindest teilweise in Vertiefungen in dem Sensorelementgehäuse verläuft, insbesondere in Vertiefungen auf einer Oberseite des Sensorelementgehäuses.

14. Bedieneinrichtung nach einem der vorhergehenden Ansprüche, **dadurch gekennzeichnet, dass** in dem Sensorelementgehäuse lichtdurchlässige Bereiche vorgesehen sind, insbesondere mit Lichtleitermaterial gefüllt, die von unten nach oben durch das Sensorelementgehäuse durchgehen.

15. Elektrogerät mit einer Bedieneinrichtung nach einem der vorhergehenden Ansprüche, **dadurch gekennzeichnet, dass** die Bedienblende Teil einer Außenwand oder Seitenwand des Elektrogeräts ist, wobei vorzugsweise das Elektrogerät ein Kochfeld ist und insbesondere die Bedienblende eine Kochfeldplatte ist.
